# EUROPEAN PATENT APPLICATION

(11) **EP 4 697 744 A1**
(43) Date of publication of application: **18.02.2026**
(21) Application number: 25192386.8
(22) Date of filing: 29.07.2025
(51) Int. Cl.: H04R 1/02, H04R 9/06

(54) **ELECTRONIC DEVICE**

(30) Priority: 14.08.2024 CN 202411114015
(71) Applicant: Harman International Industries, Inc., Stamford, Connecticut 06901 (US)
(72) Inventor: MIN, Fei, Stamford, CT, 06901 (US); XIE, Dandong, Stamford, CT, 06901 (US); WANG, Yadi, Stamford, CT, 06901 (US); FU, Haijun, Stamford, CT, 06901 (US)
(74) Representative: Westphal, Mussgnug & Partner, Patentanwälte mbB

(57) **Abstract**

An electronic device is disclosed, comprising: an electronic device housing having a housing plate portion; at least one speaker arranged in the electronic device housing, the speaker comprising: a magnetic circuit assembly defining a magnetic gap and comprising a magnet and a magnetic conductive assembly, the magnetic conductive assembly being configured to guide and concentrate magnetic flux from the magnet through the magnetic gap, the magnetic conductive assembly comprising a first magnetic conductive member constituting at least a portion of bottom of the magnetic circuit assembly, and a vibration assembly comprising a diaphragm and a voice coil connected to the diaphragm, with at least a portion of the voice coil being suspended within the magnetic gap, wherein the first magnetic conductive member of the magnetic circuit assembly is directly fixedly connected to the housing plate portion of the electronic device housing.

## Description

### Technical Field

The present invention relates to an electronic device, and particularly relates to a portable electronic device with a speaker.

### Background

In present market, slimness and high screen-to-body ratio are increasingly pursued for portable electronic devices, such as smart phones, tablet computers, or laptops, so that lateral sound-emitting design of speakers has become a main acoustic design solution for these electronic devices. This lateral sound-emitting acoustic design solution effectively utilizes edge space of an electronic device by placing the sound outlet of a speaker on a side surface of the electronic device, to maximize display screen area of the electronic device, and make an extremely narrow frame design possible. However, while achieving slimness and beauty, this design also brings some technical challenges.

High-frequency attenuation problem: In the lateral sound-emitting design, front of the speaker is usually blocked by display screen of the electronic device, and an audio generated by the speaker is transmitted to the lateral sound outlet through a lateral acoustic channel parallel to the display screen of the electronic device to emit a sound. This design has poor high-frequency response and significant attenuation in a high-frequency region, thereby resulting in insufficient ductility of a high-frequency sound. This will affect sound quality experience of a user when using the device.

Sound channel blocking problem: When using the device, the user often inadvertently blocks the lateral sound-emitting sound outlet, thereby reducing acoustic performance. In particular, when the user holds the device, his finger can very easily block the sound outlet, thereby seriously affecting sound propagation effect.

Therefore, a new lateral sound-emitting design solution is needed to improve the acoustic performance and alleviate limitations of the existing design.

### Summary of the Invention

An object of the present invention is to overcome at least some of the above problems in the prior art.

According to a first aspect of the present invention, an electronic device is provided, comprising: an electronic device housing having a housing plate portion; at least one speaker arranged in the electronic device housing, the speaker comprising: a magnetic circuit assembly defining a magnetic gap and comprising a magnet and a magnetic conductive assembly, the magnetic conductive assembly being configured to guide and concentrate magnetic flux from the magnet through the magnetic gap, the magnetic conductive assembly comprising a first magnetic conductive member constituting at least a portion of bottom of the magnetic circuit assembly, and a vibration assembly comprising a diaphragm and a voice coil connected to the diaphragm, with at least a portion of the voice coil being suspended within the magnetic gap, wherein the first magnetic conductive member of the magnetic circuit assembly is directly fixedly connected to the housing plate portion of the electronic device housing.

According to one or more embodiments of the present invention, the first magnetic conductive member is fixedly connected to the housing plate portion of the electronic device housing by riveting or bonding.

According to one or more embodiments of the present invention, the electronic apparatus housing has a first main surface, a second main surface opposite to the first main surface, and a side surface extending between the first main surface and the second main surface, and the housing plate portion is arranged on the first main surface of the electronic apparatus.

According to one or more embodiments of the present invention, the electronic device housing comprises a sound outlet disposed on the side surface, and a sound produced by the speaker is emitted through the sound outlet.

According to one or more embodiments of the present invention, the electronic device comprises a display screen provided on the second main surface.

According to one or more embodiments of the present invention, the housing plate portion is formed with a plurality of first positioning portions configured to position the first magnetic conductive member relative to the housing plate portion.

According to one or more embodiments of the present invention, the first magnetic conductive member is a yoke.

According to one or more embodiments of the present invention, the speaker further comprises a speaker housing, the speaker housing comprising a housing top wall, an opening formed in the housing top wall, and a housing sidewall extending from the housing top wall, wherein the vibration assembly is mounted in the opening of the housing top wall.

According to one or more embodiments of the present invention, the housing plate portion is formed with a plurality of second positioning portions, the speaker housing correspondingly has a plurality of housing positioning portions configured to engage with the second positioning portions of the housing plate portion, for positioning the speaker housing relative to the housing plate portion.

According to one or more embodiments of the present invention, each of the second positioning portions is formed with a recess, and each of the housing positioning portions of the speaker housing is in the form of a post, the post being configured to fit into the recess for positioning the speaker housing relative to the housing plate portion.

According to one or more embodiments of the present invention, the recess and the post are each formed with a taper.

According to one or more embodiments of the present invention, the housing plate portion is further formed with an engaging portion configured to engage with a corresponding engaging structure formed at a lower end of the housing sidewall of the speaker housing.

According to one or more embodiments of the present invention, the first magnetic conductive member constitutes an entire bottom of the magnetic circuit assembly.

According to one or more embodiments of the present invention, the housing plate portion constitutes a part of an exterior surface of the electronic device.

According to one or more embodiments of the present invention, the electronic device is a portable electronic device.

### Description of Drawings

FIG. 1 shows a perspective view of an electronic device according to one or more embodiments of the present invention;
FIG. 2 shows an exploded view of an electronic device according to one or more embodiments of the present invention;
FIG. 3A is a perspective view of the electronic device shown in FIG. 1, which is sectioned along 3A-3A line in FIG. 1 to show internal structure of the electronic device;
FIG. 3B is a partial enlarged view of a dotted line region 3B in FIG. 3A;
FIG. 4A is a section view along 3A-3A line in FIG. 1;
FIG. 4B is a partial enlarged view of a dotted line region 4B in FIG. 4A;
FIG. 5A is a section view along 5A-5A line in FIG. 1;
FIG. 5B is a partial enlarged view of a dotted line region 5B in FIG. 5A; and
FIG. 6 shows a frequency response curve diagram of an electronic device according to an embodiment and a comparative embodiment of the present invention.

### Detailed Description

Embodiments of the present invention will be described in detail below, and examples of the embodiments will be shown in the drawings, where identical or similar reference numerals in the drawings represent identical or similar elements or elements having identical or similar functions. The embodiments described below with reference to the drawings are illustrative, are merely used to explain the present invention, and should not be construed as imposing any limitation on the present disclosure.

Unless otherwise defined, the technical terms or scientific terms used here should have the ordinary meanings understood by those of ordinary skill in the field of the present invention. In the description of the present invention, it should be understood that an orientation or positional relationship indicated by the terms "center," "longitudinal," "lateral," "upper," "lower," "front," "back," "left," "right," "vertical," "horizontal," "top," "bottom," "inner," "outer," etc. is an orientation or positional relationship shown based on the accompanying drawings, is only for the convenience of describing the present invention and simplifying the description, rather than indicating or implying that a device or element referred to must have a specific orientation or be constructed and operated in a specific orientation, and thus cannot be understood as a limitation to the present invention. In addition, the terms "first" and "second" are used for descriptive purposes only, and cannot be construed as indicating or implying relative importance.

The present invention provides an electronic device, comprising an electronic device housing and at least one speaker arranged in the electronic device housing. The speaker comprises a magnetic circuit component and a vibration assembly. The first magnetic conductive member of the magnetic circuit assembly is directly fixedly connected to the housing plate portion of the electronic device housing. According to one or more embodiments of the present invention, the first magnetic conductive member is fixedly connected to the housing plate portion of the electronic device housing by riveting or bonding. According to one or more embodiments of the present invention, the first magnetic conductive member is a yoke.

In such an electronic device, the housing plate portion "directly fixedly connected" to the first magnetic conductive member (yoke) serves as a sound-emitting component of the electronic device, and improves the acoustic performance of the electronic device together with the diaphragm of the speaker.

According to one or more embodiments of the present invention, a sound outlet of the speaker is arranged on a side surface of speaker housing, and a sound produced by the speaker is emitted through the sound outlet on the side surface. This lateral sound-emitting design seriously affects high-frequency response of the sound emitted by the speaker through the lateral sound outlet because the lateral acoustic channel or path is long and narrow. In the present invention, since the housing plate portion serving as the sound-emitting component is not blocked, the high-frequency response of the electronic device is significantly improved. In addition, even if a user unintentionally blocks the lateral sound-emitting sound outlet when holding the electronic device, the acoustic performance of the electronic device will not be significantly affected.

According to one or more embodiments of the present invention, the housing plate portion is formed with a plurality of first positioning portions, the first positioning portions being configured to position the first magnetic conductive member relative to the housing plate portion. According to one or more embodiments of the present invention, the housing plate portion is formed with a plurality of second positioning portions, the speaker housing correspondingly has a plurality of housing positioning portions configured to engage with the second positioning portions of the housing plate portion, for positioning the speaker housing relative to the housing plate portion.

In such an electronic device, the magnetic circuit component is accurately positioned relative to the housing plate portion through engagement between the first positioning portions of the housing plate portion and the first magnetic conductive member (yoke), and the speaker housing and the vibration assembly (including the voice coil) connected to the speaker housing are accurately positioned relative to the housing plate portion through engagement between the housing positioning portions of the speaker housing and the second positioning portions of the housing plate portion. Therefore, the voice coil of the vibration assembly can be accurately positioned relative to the magnetic circuit assembly only by properly installing the magnetic circuit assembly to the housing plate portion and properly installing the speaker housing to the housing plate portion, thereby simplifying the installation steps.

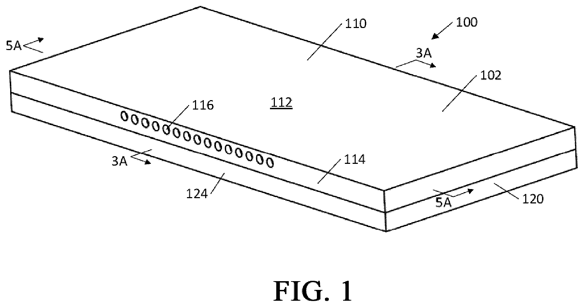

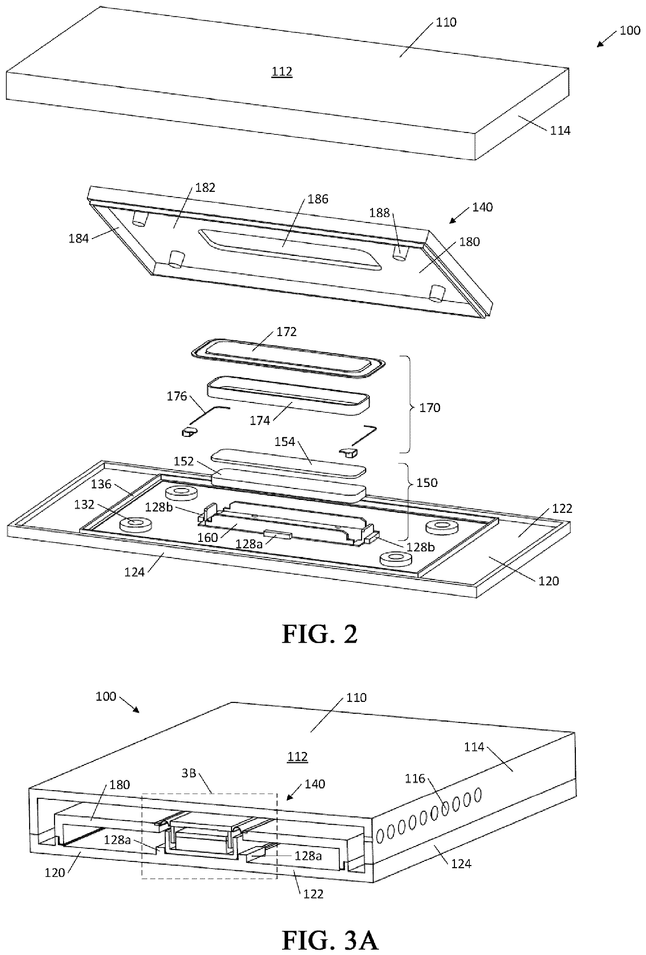

FIG. 1 shows a perspective view of an electronic device 100 according to one or more embodiments of the present invention. FIG. 2 shows an exploded view of an electronic device 100 according to one or more embodiments of the present invention. The electronic device 100 comprises a housing 102 and a speaker 140 arranged in the housing 102. The housing 102 comprises an upper housing portion 110 and a lower housing portion 120. The upper housing portion 110 has an upper housing plate portion 112 and an upper sidewall portion 114 extending from the upper housing plate portion 112. The upper housing portion 110 further comprises a row of sound outlets 116 formed on the upper sidewall portion 114 thereof. The lower housing portion 120 has a lower housing plate portion 122 and a lower sidewall portion 124 extending from the lower housing plate portion 122. The upper housing portion 110 and the lower housing portion 120 are engaged together to form the housing 102 defining an internal accommodating space. The speaker 140 is arranged in the internal accommodating space defined by the housing 102. The speaker 140 comprises a magnetic circuit assembly 150, a vibration assembly 170, and a speaker housing 180. The magnetic circuit assembly 150 comprises a magnet 152, a top plate 154, and a yoke 160. The vibration assembly 170 comprises a diaphragm 172 and a voice coil 174 connected to the diaphragm 172. The voice coil 174 is further connected with a leading wire 176, and an audio signal is transmitted to the voice coil 174 through the leading wire 176.

The electronic device 100 shown in FIGS. 1 and 2 is illustrative, and comprises only one speaker 140. In one or more embodiments according to the present invention, the electronic device 100 may be any suitable portable electronic device, such as a smart phone, a tablet computer, or a notebook computer. In one or more other embodiments according to the present invention, the electronic device 100 may be any suitable electronic device. These electronic devices or portable electronic devices may comprise a plurality of speakers, such as 2, 3, 4, or more speakers. Accordingly, the electronic device 100 further comprises a plurality of rows of sound outlets 116 or a plurality of sound outlet arrays corresponding to the plurality of speakers. In addition to the speakers, these electronic devices may further comprise other electron devices. For example, in one or more embodiments, a display screen is arranged on front side (the upper housing plate portion 112) of the electronic device. In one or more embodiments, the electronic device further comprises an electron device, such as a processor (e.g., a CPU or an MCU), a storage device, or a battery.

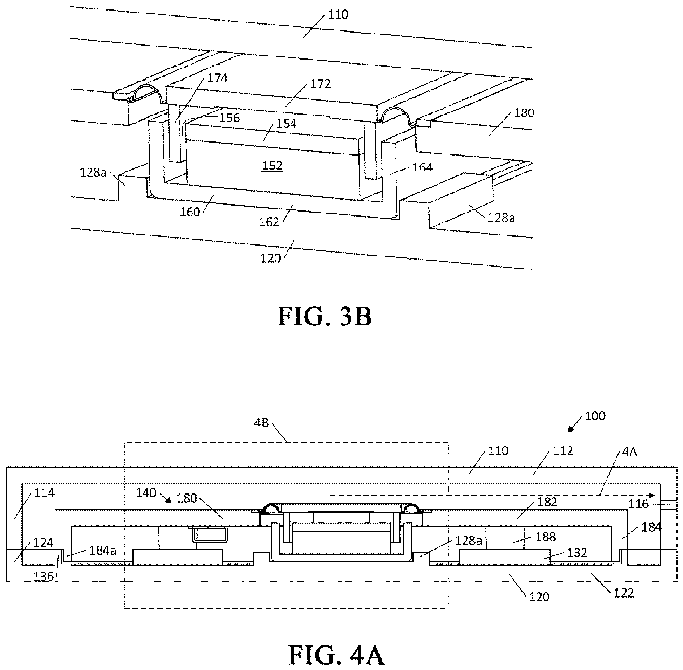

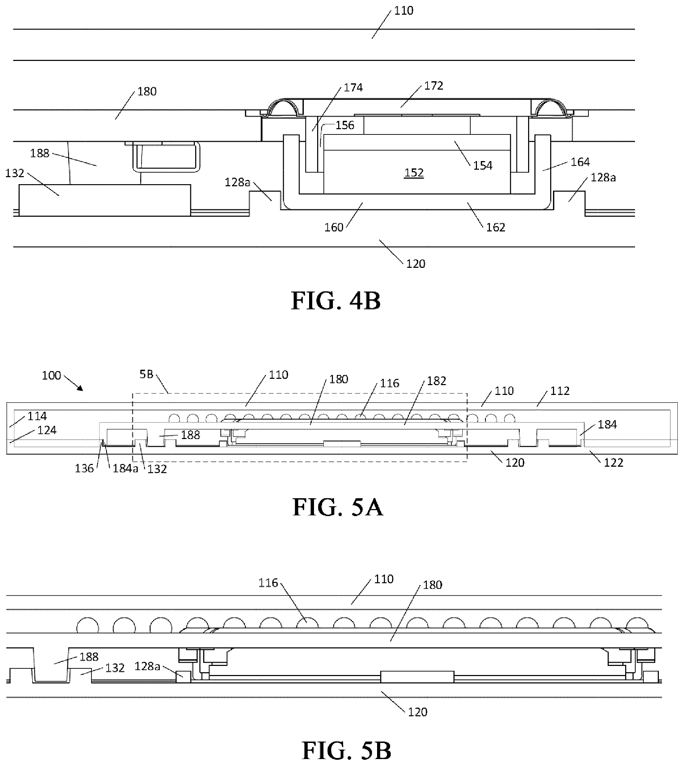

FIG. 3A is a perspective view of the electronic device 100 shown in FIG. 1, which is sectioned along 3A-3A line in FIG. 1 to show internal structure of the electronic device 100. FIG. 3B is a partial enlarged view of a dotted line region 3B in FIG. 3A. FIG. 4A is a section view along 3A-3A line in FIG. 1, and FIG. 4B is a partial enlarged view of a dotted line region 4B in FIG. 4A.

As shown in the figures, the magnetic circuit assembly comprises a magnet 152, a top plate 154, and a yoke 160. The magnetic circuit assembly 150 further defines a magnetic gap 156 between the yoke 160 and the top plate 154. The yoke 160 comprises a bottom 162 and a sidewall 164. The bottom 162 and the sidewall 164 of the yoke 160 constitute an accommodating space. The magnet 152 and the top plate 154 are arranged in the accommodating space. The top plate 154 and the bottom 162 of the yoke 160 are configured to sandwich the magnet 152 therebetween. Structure and shape of the top plate 154 and the yoke 160 are configured to guide and gather magnetic flux from the magnet 152 through the magnetic gap 156 between the top plate 154 and the sidewall 164 of the yoke 160. The vibration assembly 170 comprises a diaphragm 172 and a voice coil 174. Radial outer end of the diaphragm 172 is connected to the speaker housing 180. Upper end of the voice coil 174 is connected to the diaphragm 172, and coil portion of the voice coil 174 is suspended in the magnetic gap 156. The leading wire 176 of the voice coil 174 is electrically connected to coil portion of the voice coil 174, and is configured to transmit an audio electrical signal to the coil portion of the voice coil 174. When the audio electrical signal flows through the coil portion of the voice coil 174, the coil portion of the voice coil 174 in the magnetic gap 156 vibrates back and forth along axis direction of the speaker 140 under the action of an electromagnetic force, thereby driving the diaphragm 172 to vibrate and emit a sound. A specific structure of the speaker 140 shown in the figure is illustrative. In one or more other embodiments according to the present invention, the speaker of the electronic device 100 may be of any suitable structure. For example, the magnetic circuit assembly of the speaker may have any suitable structure, and the vibration assembly of the speaker may have any suitable structure.

The electronic device 100 adopts a lateral sound-emitting design, that is, the sound outlet 116 of the electronic device 100 is not arranged on the upper housing plate portion 112 of the upper housing portion 110 facing the diaphragm 172 of the speaker 140 or its vibration assembly 170, but is arranged on the upper sidewall portion 114 of the upper housing portion 110. When the electronic device 100 is, e.g., a smart phone, a tablet computer, or a notebook computer comprising a display screen, such as an LCD screen, at least a portion of the upper housing plate portion 112 of the upper housing portion 110 may be a display screen. This lateral sound-emitting acoustic design as shown in the figure effectively utilizes lateral space of the electronic device by placing the sound outlet of the speaker on a side surface of the electronic device (no sound outlet on front side of the electronic device), to maximize display screen area of the electronic device, and make an extremely narrow frame design possible.

However, the lateral sound-emitting design of the electronic device 100 also brings some problems. As shown in FIG. 4A, since front of the speaker 140 is blocked by the upper housing plate portion 112 (e.g., the display screen) of the upper housing portion 110 of the electronic device 100, an audio generated by the speaker 140 is transmitted to the lateral sound outlet 116 through a lateral acoustic channel or path (indicated by a dotted arrow 4A) parallel to the display screen of the electronic device to emit a sound. The lateral acoustic channel or path has a relatively large length. Due to the requirements for thinness of electronic devices, the lateral acoustic channel or path is usually relatively narrow. This long and narrow lateral acoustic channel or path seriously affects high-frequency response of the sound emitted by the speaker of the electronic device 100 through the lateral sound outlet 116, that is, the attenuation in a high-frequency region is significant, thereby resulting in insufficient ductility of a high-frequency sound. In addition, when holding the electronic device for use, a user often inadvertently blocks the lateral sound-emitting sound outlet 116. This will further reduce the acoustic performance of the sound emitted by the speaker of the electronic device 100 through the lateral sound outlet 116.

In the electronic device 100, the yoke 160 is directly fixedly connected to the lower housing plate portion 122 of the lower housing portion 120 of the electronic device 100. In one or more embodiments, the yoke 160 is directly fixedly connected to the lower housing plate portion 122 of the lower housing portion 120 by riveting or bonding. The "directly" in the "directly fixedly connected" here means that no other intermediate element is present between the yoke 160 and the lower housing plate portion 122 of the lower housing portion 120, and the "fixedly connected" means that the yoke 160 and the lower housing plate portion 122 connected thereto are fixed together through connection. For example, when the speaker 140 is working, the yoke 160 can vibrate together with the lower housing plate portion 122 connected thereto without or substantially without relative movement. In one or more embodiments, the lower housing plate portion 122 connected to the yoke 160 is plate-shaped or tabulate.

When the speaker 140 is working, the coil portion of the voice coil 174 in the magnetic gap 156 vibrates back and forth along the axis direction of the speaker 140 under the action of an electromagnetic force, thereby driving the diaphragm 172 to vibrate and emit a sound. Further, counterforce of the electromagnetic force also serves on the magnetic circuit assembly 150 of the speaker 140, so that when the speaker 140 is working, its magnetic circuit assembly 150 (including the yoke 160) also vibrates accordingly.

The "direct fixed connection" between the yoke 160 and the lower housing plate portion 122 of the lower housing portion 120 ensures that when the speaker 140 is working, the yoke 160 can effectively drive the lower housing plate portion 122 of the lower housing portion 120 to vibrate together, thereby emitting a sound. Therefore, through the "direct fixed connection" between the yoke 160 and the lower housing plate portion 122 of the lower housing portion 120, the lower housing plate portion 122 of the lower housing portion 120 of the electronic device 100 also serves as a sound-emitting component. Since the lower housing plate portion 122 serving as the sound-emitting component is not blocked, high-frequency response of the electronic device 100 is significantly improved. In addition, even if the user unintentionally blocks the lateral sound-emitting sound outlet 116 when holding the electronic device, the acoustic performance of the electronic device 100 will not be significantly affected.

In the embodiment as shown in the figure, the electronic device 100 adopts a lateral sound-emitting design. The present invention is not limited to this. In one or more other embodiments according to the present invention, the electronic device 100 may also adopt, e.g., a front sound-emitting design, that is, the sound outlet is in the front of the vibration assembly of the speaker. In such an electronic device 100, the lower housing plate portion 122 "directly fixedly connected" to the yoke also serves as a sound-emitting component of the electronic device 100, and improves the acoustic performance of the electronic device together with the front sound-emitting speaker design.

In the embodiment as shown in the figure, the yoke 160 of the electronic device 100 is "directly fixedly connected" to the lower housing plate portion 122, so that the lower housing plate portion 122 can serve as a sound-emitting component to improve the acoustic performance of the electronic device. The present invention is not limited to this. In one or more other embodiments according to the present invention, the "direct fixed connection" to the lower housing plate portion 122 may not be limited to the yoke, but may be other magnetic conductive members of the magnetic circuit assembly.

The lower housing plate portion 122 of the lower housing portion 120 also has first positioning portions 128a and 128b for positioning the yoke 160 at a suitable position. In the embodiment as shown in the figure, the yoke 160 of the speaker 140 is substantially rectangular, and the lower housing plate portion 122 has four first positioning portions 128a and 128b. The two first positioning portions 128a are engaged with two long sides of the yoke 160 respectively, and the two first positioning portions 128b are engaged with two short sides of the yoke 160 respectively. The four first positioning portions 128a and 128b can accurately position the yoke 160, and thus the magnetic circuit assembly 150 relative to the lower housing plate portion 122. In one or more other embodiments according to the present invention, the lower housing plate portion 122 may include other numbers of the first positioning portions. For example, more than one first positioning portion may be included on one or more sides of the yoke 160. In one or more other embodiments according to the present invention, the first positioning portions may be distributed on only 2 or 3 sides of the yoke 160.

In one or more other embodiments according to the present invention, the yoke 160 may be in a shape other than a rectangle, and/or there may be any suitable number of the first positioning portions on the lower housing plate portion 122, as long as these first positioning portions can position the yoke 160 relative to the lower housing plate portion 122. In one or more embodiments according to the present invention, the first positioning portions 128a and 128b may be integrally formed with the lower housing plate portion 122. In one or more other embodiments according to the present invention, the first positioning portions 128a and 128b may be connected to the lower housing plate portion 122 in any suitable manner.

The speaker housing 180 comprises a housing top wall 182 and a housing sidewall 184 extending from the housing top wall 182. The speaker housing 180 further comprises an opening 186 formed in the housing top wall 182. The vibration assembly 170 is connected to the opening 186 in the housing top wall 182 of the speaker housing 180. In one or more embodiments, radially outer end of the diaphragm 172 of the vibration assembly 170 is connected to a corresponding connection structure at the opening 186 in the housing top wall 182, so that the vibration assembly 170 (including the diaphragm 172 and the voice coil 174) can be accurately positioned relative to the speaker housing 180.

FIG. 5A is a section view along 5A-5A line in FIG. 1, and FIG. 5B is a partial enlarged view of a dotted line region 5B in FIG. 5A. As shown in the figure, the lower housing plate portion 122 of the lower housing portion 120 further has a plurality of second positioning portions 132. Correspondingly, the speaker housing 180 has a plurality of housing positioning portions 188. The housing positioning portions 188 of the speaker housing 180 are engaged with the second positioning portions 132 of the lower housing plate portion 122 of the lower housing portion 120, for positioning the speaker housing 180 at a suitable position relative to the lower housing plate portion 122.

In the embodiment as shown in the figure, each of the second positioning portions 132 of the lower housing plate portion 122 is formed with a recess, and each of the housing positioning portions 188 of the speaker housing 180 is in the form of a post. The housing positioning portions 188 in the form of the post are fit into the recesses of the second positioning portions 132, for accurately positioning the speaker housing 180 relative to the lower housing plate portion 122. In one or more embodiments according to the present invention, the recesses of the second positioning portions 132 and the posts of the housing positioning portions 188 are each formed with a taper. When the speaker housing 180 is mounted to the lower housing plate portion 122, the taper helps to automatically align the speaker housing 180 relative to the lower housing plate portion 122. In one or more other embodiments according to the present invention, the second positioning portions 132 of the lower housing plate portion 122 and the housing positioning portions 188 of the speaker housing 180 may be in other forms, as long as they can achieve accurate positioning of the speaker housing 180 relative to the lower housing plate portion 122. In one or more other embodiments according to the present invention, the second positioning portions 132 of the lower housing plate portion 122 and the housing positioning portions 188 of the speaker housing 180 may be omitted.

In the embodiment as shown in the figure, the yoke 160 and the magnetic circuit assembly 150 are accurately positioned relative to the lower housing plate portion 122 through engagement between the first positioning portions 128a and 128b of the lower housing plate portion 122 and the yoke 160, and the speaker housing 180 and the vibration assembly 170 (including the voice coil 174) connected to the speaker housing 180 are accurately positioned relative to the lower housing plate portion 122 through engagement between the housing positioning portions 188 of the speaker housing 180 and the second positioning portions 132 of the lower housing plate portion 122 of the lower housing portion 120. Therefore, the voice coil 174 of the vibration assembly 170 can be accurately positioned relative to the magnetic circuit assembly 150 only by properly installing the magnetic circuit assembly 150 to the lower housing plate portion 122 and properly installing the speaker housing 180 to the lower housing plate portion 122, thereby simplifying the installation steps.

As shown in FIG. 2, the lower housing plate portion 122 comprises four second positioning portions 132, which are arranged around the yoke 160 of the speaker 140. The speaker housing 180 also comprises four housing positioning portions 188 accordingly. In one or more embodiments according to the present invention, there may be other numbers, such as 2, 3, or 5, of the second positioning portions 132 of the lower housing plate portion 122 and the housing positioning portions 188 of the speaker housing 180.

In the embodiment as shown in the figure, the lower housing plate portion 122 is further formed with an engaging portion 136. The engaging portion 136 of the lower housing plate portion 122 is configured to engage with a corresponding engaging structure 184a formed at a lower end of the housing sidewall 184 of the speaker housing 180. The engagement between the two helps to isolate and seal the inside of the speaker housing 180 from the external space. Further, the engagement between the two also helps to position the speaker housing 180 relative to the lower housing plate portion 122.

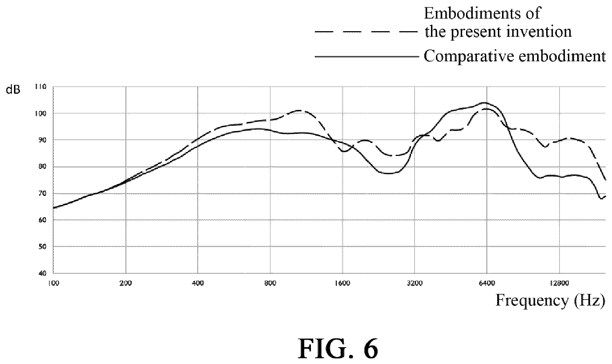

FIG. 6 shows a frequency response curve diagram of an electronic device according to an embodiment and a comparative embodiment of the present invention, in which the dotted line is a frequency response curve of the electronic device in the embodiments as shown in FIGS. 1-5B and the solid line is a frequency response curve of the electronic device in the comparative embodiment. The structure of the electronic device in this comparative embodiment is substantially same as that in the embodiment shown in FIGS. 1-5B, merely except that the speaker housing of the speaker in the comparative embodiment comprises a bottom wall, and the yoke is installed in the speaker housing instead of being directly fixed to the electronic device housing (lower housing plate portion). As shown in FIG. 6, the electronic device according to the embodiments of the present invention has significant improvement in high-frequency response. In addition, the electronic device according to the embodiments of the present invention further has improvement in overall loudness.

The present invention can be implemented as follows:
Item 1: An electronic device, comprising: an electronic device housing having a housing plate portion; at least one speaker arranged in the electronic device housing, the speaker comprising: a magnetic circuit assembly defining a magnetic gap and comprising a magnet and a magnetic conductive assembly, the magnetic conductive assembly being configured to guide and concentrate magnetic flux from the magnet through the magnetic gap, the magnetic conductive assembly comprising a first magnetic conductive member constituting at least a portion of bottom of the magnetic circuit assembly, and a vibration assembly comprising a diaphragm and a voice coil connected to the diaphragm, with at least a portion of the voice coil being suspended within the magnetic gap, wherein the first magnetic conductive member of the magnetic circuit assembly is directly fixedly connected to the housing plate portion of the electronic device housing.
Item 2: The electronic device according to item 1, wherein the first magnetic conductive member is fixedly connected to the housing plate portion of the electronic device housing by riveting or bonding.
Item 3: The electronic device according to any one of items 1 to 2, wherein the electronic device housing has a first main surface and a second main surface opposite to the first main surface, and a side surface extending between the first main surface and the second main surface, wherein the housing plate portion is disposed on the first main surface of the electronic device.
Item 4: The electronic device according to any one of items 1 to 3, wherein the electronic device housing comprises a sound outlet disposed on the side surface, and a sound produced by the speaker is emitted through the sound outlet.
Item 5: An electronic device according to any one of items 1 to 4, wherein the electronic device comprises a display screen on the second main surface.
Item 6: The electronic device according to any one of items 1 to 5, wherein the housing plate portion is formed with a plurality of first positioning portions configured to position the first magnetic conductive member relative to the housing plate portion.
Item 7: The electronic device according to any one of items 1 to 6, wherein the first magnetic conductive member is a yoke.
Item 8: The electronic device according to any one of items 1 to 7, wherein the speaker further comprises a speaker housing, the speaker housing comprising a housing top wall, an opening formed in the housing top wall, and a housing sidewall extending from the housing top wall, wherein the vibration assembly is mounted in the opening of the housing top wall.
Item 9: The electronic device according to any one of items 1 to 8, wherein the housing plate portion is formed with a plurality of second positioning portions, the speaker housing correspondingly has a plurality of housing positioning portions configured to engage with the second positioning portions of the housing plate portion, for positioning the speaker housing relative to the housing plate portion.
Item 10: The electronic device according to any one of items 1 to 9, wherein each of the second positioning portions is formed with a recess, and each of the housing positioning portions of the speaker housing is in the form of a post, the post being configured to fit into the recess for positioning the speaker housing relative to the housing plate portion.
Item 11: The electronic device according to any one of items 1 to 10, wherein the recess and the post are each formed with a taper.
Item 12: The electronic device according to any one of items 1 to 11, wherein the housing plate portion is further formed with an engaging portion configured to engage with a corresponding engaging structure formed at a lower end of the housing sidewall of the speaker housing.
Item 13: The electronic device according to any one of items 1 to 12, wherein the first magnetic conductive member constitutes an entire bottom of the magnetic circuit assembly.
Item 14: The electronic device according to any one of items 1 to 13, wherein the housing plate portion constitutes a part of an exterior surface of the electronic device.
Item 15: The electronic device according to any one of items 1 to 14, wherein the electronic device is a portable electronic device.

The above description merely provides example embodiments to illustrate the principle of the present invention, and is not intended to limit the scope of protection of the present invention. For those of ordinary skill in the art, various modifications and improvements can be made without departing from the spirit and essence of the present invention, and these modifications and improvements are also within the protection scope of the present invention.

## Claims

1. An electronic device, comprising:
an electronic device housing having a housing plate portion;
at least one speaker arranged in the electronic device housing, the speaker comprising:
a magnetic circuit assembly defining a magnetic gap and comprising a magnet and a magnetic conductive assembly, the magnetic conductive assembly being configured to guide and concentrate magnetic flux from the magnet through the magnetic gap, the magnetic conductive assembly comprising a first magnetic conductive member constituting at least a portion of bottom of the magnetic circuit assembly, and
a vibration assembly comprising a diaphragm and a voice coil connected to the diaphragm, with at least a portion of the voice coil being suspended within the magnetic gap,
wherein the first magnetic conductive member of the magnetic circuit assembly is directly fixedly connected to the housing plate portion of the electronic device housing.

2. The electronic device according to claim 1, wherein the first magnetic conductive member is fixedly connected to the housing plate portion of the electronic device housing by riveting or bonding.

3. The electronic device according to claim 1, wherein the electronic device housing has a first main surface and a second main surface opposite to the first main surface, and a side surface extending between the first main surface and the second main surface, wherein the housing plate portion is disposed on the first main surface of the electronic device.

4. The electronic device according to claim 3, wherein the electronic device housing comprises a sound outlet disposed on the side surface, and a sound produced by the speaker is emitted through the sound outlet.

5. The electronic device according to claim 3, wherein the electronic device comprises a display screen on the second main surface.

6. The electronic device according to claim 1, wherein the housing plate portion is formed with a plurality of first positioning portions configured to engage with the first magnetic conductive member, for positioning the first magnetic conductive member relative to the housing plate portion.

7. The electronic device according to claim 1, wherein the first magnetic conductive member is a yoke.

8. The electronic device according to any one of claims 1 to 7, wherein the speaker further comprises a speaker housing, the speaker housing comprising a housing top wall, an opening formed in the housing top wall, and a housing sidewall extending from the housing top wall, wherein the vibration assembly is mounted in the opening of the housing top wall.

9. The electronic device according to claim 8, wherein the housing plate portion is formed with a plurality of second positioning portions, the speaker housing correspondingly has a plurality of housing positioning portions configured to engage with the second positioning portions of the housing plate portion, for positioning the speaker housing relative to the housing plate portion.

10. The electronic device according to claim 9, wherein each of the second positioning portions is formed with a recess, and each of the housing positioning portions of the speaker housing is in the form of a post, the post being configured to fit into the recess for positioning the speaker housing relative to the housing plate portion.

11. The electronic device according to claim 10, wherein the recess and the post are each formed with a taper.

12. The electronic device according to claim 8, wherein the housing plate portion is further formed with an engaging portion configured to engage with a corresponding engaging structure formed at a lower end of the housing sidewall of the speaker housing.

13. The electronic device according to any one of claims 1 to 7, wherein the first magnetic conductive member constitutes an entire bottom of the magnetic circuit assembly.

14. The electronic device according to any one of claims 1 to 7, wherein the housing plate portion constitutes a part of an exterior surface of the electronic device.

15. The electronic device according to any one of claims 1 to 7, wherein the electronic device is a portable electronic device.
